# EUROPÄISCHE PATENTSCHRIFT

(11) **EP 2 895 349 B1**
(45) Veröffentlichungstag und Bekanntmachung des Hinweises auf die Patenterteilung: **12.10.2016**
(21) Anmeldenummer: 13752585.3
(22) Anmeldetag: 09.08.2013
(51) Int. Cl.: B60K 37/06

(54) **VERFAHREN ZUM BEDIENEN EINER FUNKTIONSEINRICHTUNG EINES KRAFTFAHRZEUGS**
METHOD FOR CONTROLLING A FUNCTIONAL DEVICE OF A MOTOR VEHICLE
PROCEDE DE COMMANDE D'UN DISPOSITIF FONCTIONNEL D'UN VEHICULE À MOTEUR

(30) Priorität: 14.09.2012 DE 102012018211
(43) Veröffentlichungstag der Anmeldung: 22.07.2015
(73) Patentinhaber: Audi AG, 85045 Ingolstadt (DE)
(72) Erfinder: BOUAZIZ, Tahar, 85055 Ingolstadt (DE); HAMBERGER, Werner, 85101 Lenting (DE); STEINLE, Jürgen, 85049 Ingolstadt (DE); ANGELESCU, Emanuel, 50858 Köln (DE); MÜLLER, Ulrich, 85055 Ingolstadt (DE)
(74) Vertreter: Brandt, Kai
(86) Internationale Anmeldenummer: PCT/EP2013/002393
(87) Internationale Veröffentlichungsnummer: WO 2014/040675

(56) Entgegenhaltungen:
- EP-A2- 1 168 622
- DE-A1-102006 052 653
- DE-A1-102007 039 318
- DE-A1-102010 055 831
- US-A1- 2009 140 993
- US-A1- 2012 131 455

## Beschreibung

Die vorliegende Erfindung betrifft ein Verfahren zum Bedienen einer Funktionseinrichtung eines Kraftfahrzeugs mit einer Bedienvorrichtung.

Zur Bedienung von Funktionseinrichtungen eines Kraftfahrzeugs sind entsprechende Bedienvorrichtungen vorgesehen. Diese können einen Drehsteller oder Drehencoder umfassen. Heutige Drehsteller besitzen mechanische Raststellungen in denen sie entlang ihrer Drehrichtung einrasten. Diese Rastpositionen werden vom Nutzer bzw. der Bedienperson haptisch wahrgenommen. Oft wird auch zusätzlich ein akustisches Signal, beispielsweise ein Klicken, ausgegeben. Diese Art von Drehsteller sind weit verbreitet und kommen beispielsweise in Klimabedienteilen oder der zentralen Eingabeeinheit im Kraftfahrzeug zum Einsatz. In der Regel werden die Drehsteller zur Weiterschaltung einer diskreten Funktion genutzt. Beispielsweise wird in einem Klimabedienteil die Temperatur pro Raststufe um eine vorgegebene Temperatur erhöht oder die Geschwindigkeit eines Lüfters wird hochgesetzt.

Heutige, auf herkömmliche Drehsteller optimierte, grafische Benutzerschnittstellen basieren in ihrer Systemreaktion auf den diskreten Raststellungen der mechanischen Drehsteller. So wird in grafisch basierten Systemen, wie einer Mensch-Maschine-Schnittstelle, der zentrale Drehsteller zur Navigation im Display genutzt. Dabei bewirkt eine Verstellung des Drehstellers um eine Rastposition eine Verschiebung der Bildschirmdarstellung um einen Schritt nach oben oder nach unten. Bei einem Navigationssystem kann durch die Verstellung des Drehstellers um eine Rastposition eine Vergrößerung bzw. eine Verkleinerung der Kartendarstellung um eine Stufe bewirkt werden.

Folglich werden die einzelnen Rastpositionen des Drehstellers einem Bediener zunächst haptisch taktil sowie häufig auch über einen Klick akustisch zurückgemeldet. Ist dies erfolgt, wird anschließend die grafische Darstellung in einen neuen Systemzustand überführt. Zwischen dem Überführen der Darstellung in den neuen Systemzustand kann auch eine kurze Animation vorgesehen sein. Aufgrund dieser festgelegten Abfolge von Systemereignissen, werden für den Benutzer Folgen seiner Handlung immer erst nach dem Erreichen der Raststellung des Drehstellers sichtbar gemacht. Dementsprechend kann der Benutzer eine fehlerhafte oder ungewollte Eingabe mit dem Drehsteller erst feststellen, nachdem das System in einen neuen Zustand überführt wurde.

Die DE 10 2007 009 938 A1 beschreibt eine Bedienvorrichtung in einem Kraftfahrzeug zum Auswählen eines von mehreren in einer Liste angeordneten Objekten. Die Bedienvorrichtung umfasst eine Eingabevorrichtung, die als Dreh-/Drücksteller ausgebildet sein kann, und eine Anzeigevorrichtung. Die Anzeige der Anzeigevorrichtung kann in Abhängigkeit von der Drehrichtung und der Drehgeschwindigkeit des Drehstellers angepasst werden.

Des Weiteren beschreibt die US 2011/061051 A1 ein Verfahren zum Darstellen von Informationen in einem Kraftfahrzeug. In Abhängigkeit von dem Signal einer Steuereinrichtung, die als Drehsteller ausgebildet sein kann, kann die Darstellung eines Objekts in zumindest zwei Darstellungsarten erfolgen. In einer ersten Darstellungsart wird eine Teilmenge einer Gesamtinformation dargestellt. bei der zweiten Darstellungsart wird das Objekt perspektivisch oder dreidimensional relativ zur ersten Darstellungsart des Objekts um eine Achse geschwenkt gezeigt, wobei bei der zweiten Darstellungsart die von dem Objekt wiedergegebene Teilmenge der Gesamtinformation größer ist als die bei der ersten Darstellungsart.

Darüber hinaus beschreibt die EP 1 075 979 A2 ein Verfahren zum Betrieb einer Multifunktionsbedieneinrichtung, die eine Anzeigeeinrichtung und ein Drehbetätigungselement umfasst. Das Drehbetätigungselement ist hinsichtlich Drehrichtungen, Drehstellungen und/oder Raststellungen und/oder Betätigungsanschlägen frei programmierbar, derart, dass haptische Rückmeldungen im Drehbetätigungsweg erzeugt werden, die jeweiligen Menüs oder Funktionen zugeordnet sind.

Zudem offenbart die DE 10 2005 025 887 A1 eine Bedieneinrichtung für ein Kraftfahrzeug mit einem Dreh-/Drückbedienelement. Das Dreh-/Drückbedienelement ist derart ausgebildet, dass durch seine Betätigung ein Markierungselement auf einer Anzeigevorrichtung bewegbar ist, wobei während einer Drehbewegung des Dreh-/Drückbedienelements Rastpositionen vorgegeben sind.

Die DE 10 2009 057 950 A1 beschreibt eine Einstellvorrichtung für ein Fahrzeug mit einer Stelleinrichtung zum Einstellen eines gewünschten Betriebsparameters, die zwischen einem Minimalwert und einem Maximalwert eine Vielzahl von Einstellpositionen einnehmen kann. Die Stelleinrichtung kann als Drehregler ausgeführt sein, wobei sich je nach Einstellposition des Drehreglers eine Position eines Zeigers auf einer Anzeigevorrichtung ändert.

Schließlich beschreibt die DE 10 2008 057 098 A1 einen Drehsteller für ein Fahrzeug, der eine Rastung und eine Bewegungserfassung aufweist. Mit einer Sensoreinrichtung des Drehstellers kann die Drehrichtung und der Drehwinkel eines Stellelements erfasst werden.

Die US2009/140993A1 offenbart ein Verfahren zum Bedienen einer Funktionseinrichtung eines Kraftfahrzeugs gemäß dem Oberbegriff des Anspruchs 1.

Es ist Aufgabe der vorliegenden Erfindung, das Bedienen einer Funktionseinrichtung eines Kraftfahrzeugs mit einer Bedienvorrichtung einfacher und intuitiver zu gestalten.

Diese Aufgabe wird durch ein Verfahren mit den Merkmalen des Patentanspruchs 1 gelöst. Vorteilhafte Weiterbildungen der vorliegenden Erfindung sind in den Unteransprüchen angegeben.

Das erfindungsgemäße Verfahren zum Bedienen einer Funktionseinrichtung eines Kraftfahrzeugs mit einer Bedienvorrichtung, wobei die Bedienvorrichtung einen Drehsteller umfasst, der an einem Halteelement drehbar gelagert ist und der zumindest ein Kodierelement aufweist, umfasst das Erfassen eines absoluten Drehwinkels zwischen dem Drehsteller und dem Halteelement anhand einer Kodierung des zumindest einen Kodierelements, das Vorgeben einer Mehrzahl von Rastpositionen für den Drehsteller entlang seiner Drehrichtung, das Erfassen der jeweiligen Rastposition und des absoluten Drehwinkels zwischen zumindest zwei der Rastpositionen anhand der Kodierung des zumindest einen Kodierelements und das Steuern der Funktionseinrichtung in Abhängigkeit von dem erfassten absoluten Drehwinkel, falls sich der Drehsteller zwischen zwei der Rastpositionen befindet.

Die Bedienvorrichtung kann im Armaturenbrett oder in der Mittelkonsole des Kraftfahrzeugs angeordnet sein. Das Kraftfahrzeug kann auch mehrere Bedienvorrichtungen umfassen, mit denen Funktionseinrichtungen, wie z. B. eine Klimaanlage, ein Navigationssystem, eine Bedieneinrichtung mit dazugehöriger Anzeige, ein Unterhaltungssystem oder dergleichen, angesteuert werden können. Die Bedienvorrichtung umfasst einen Drehsteller, der auch als Dreh-/Drücksteller ausgebildet sein kann. Darüber hinaus umfasst die Bedienvorrichtung eine Rasteinrichtung, die dem Drehsteller mehrere Raststufen bzw. Rastpositionen vorgibt. An dem Drehsteller ist zumindest ein Kodierelement angeordnet, das mit einer Erfassungseinrichtung erfasst werden kann. Die Erfassungseinrichtung der Bedienvorrichtung ist nun dazu ausgebildet, anhand der Kodierung des zumindest einen Kodierelements die vorgegebenen Rastpositionen einzeln zu erfassen. Zudem kann mit der Erfassungseinrichtung der absolute Drehwinkel zwischen mindestens zwei Rastpositionen erfasst werden. Des Weiteren kann mit der Erfassungseinrichtung anhand der Kodierung des zumindest einen Kodierelements die Drehrichtung des Drehstellers erfasst werden. Bei der Bedienvorrichtung sind die diskreten Rastpositionen vorhanden, die durch die haptische Rückmeldung beim Benutzer ein hochwertiges Bediengefühl hervorrufen. Darüber hinaus können leichte Auslenkungen des Drehstellers vor dem Einrasten in die nächste Rastposition mit der Erfassungseinrichtung erkannt werden. Dadurch können auf einfache Weise neben den Rastpositionen auch die Zwischenstellungen zwischen den Raststufen mit einer hohen Auflösung erfasst werden und ein entsprechendes Steuersignal zur Bedienung der Funktionseinrichtung ausgegeben werden.

Bevorzugt wird für jede die erfassten Rastpositionen ein Raststeuersignal zur Steuerung der Funktionseinrichtung ausgegeben. Mit dem jeweiligen Raststeuersignal können Einstellungen von Funktionseinrichtungen des Kraftfahrzeugs bereitgestellt werden, die in diskreten Schritten oder Stufen erfolgen. Durch die einzelnen Raststufen und die dazugehörige Ansteuerung der Funktionseinrichtung kann eine einfache und intuitive Bedienung ermöglicht werden. Zudem ergibt sich für den Bediener ein besonders hochwertiger Eindruck.

In einer weiteren Ausführungsform wird in Abhängigkeit von dem erfassten Drehwinkel zwischen den zwei Rastpositionen zumindest ein Zwischensteuersignal zur Steuerung der Funktionseinrichtung ausgegeben. Mit der Bedienvorrichtung können leichte Auslenkungen des Drehstellers vor dem Einrasten in die nächste Rastposition erkannt werden. Dadurch können auf einfache Weise neben den Rastpositionen auch die Zwischenstellungen zwischen den Raststufen mit einer hohen Auflösung erfasst werden und entsprechende Zwischensteuersignale zur Steuerung der Funktionseinrichtung ausgegeben werden. Damit kann die Funktionalität der Bedienvorrichtung erweitert werden.

In eine weiteren Ausgestaltung wird zwischen den zwei Rastpositionen eine Mehrzahl von Zwischenpositionen festgelegt, wobei für jede der Zwischenpositionen ein Zwischensteuersignal zur Steuerung der Funktionseinrichtung ausgegeben wird. Durch die einzelnen Zwischenstufen wird die Funktionalität der Bedienvorrichtung zusätzlich erweitert. Wenn eine ausreichende Anzahl an Zwischenpositionen vorgesehen ist, kann ein beinahe kontinuierliche Bedienung einer Funktionseinrichtung ermöglicht werden. Zudem kann der Bediener in vielen Zwischenschritten über seine Handlung informiert werden.

Weiterhin ist es vorteilhaft, wenn die Funktionseinrichtung eine Anzeigevorrichtung umfasst, wobei eine Darstellung auf der Anzeigeeinrichtung in Abhängigkeit von den Raststeuersignalen und/oder dem zumindest einen Zwischensteuersignal angepasst wird. Die einzelnen Rastpositionen des Drehstellers können direkt mit den grafischen Raststufen der Darstellung auf der Anzeigeeinrichtung gekoppelt sein. So können die Rastpositionen mit vorgegebenen Darstellungen synchronisiert sein. Durch die Zwischensignale und die damit verbundene Änderung der Darstellung kann eine Bedienperson über die Konsequenzen ihrer Bedienhandlung schneller aufgeklärt werden. Zudem wird die Bedienvorrichtung durch die verzögerungsfreie und beinahe stufenlose Umsetzung von Befehlen deutlich hochwertiger wahrgenommen.

In einer weiteren Ausführungsform wird die Darstellung auf der Anzeigeeinrichtung durch jedes der Raststeuersignale um einen vorgegebenen ersten Faktor vergrößert oder verkleinert. Dies ermöglicht beispielsweise ein schrittweises Zoomen in einer Kartendarstellung eines Navigationssystems. Dabei ist es auch denkbar, dass eine Darstellung auf der Anzeigeeinrichtung durch jedes der Raststeuersignale entsprechend verschoben wird. Durch die einzelnen Raststeuersignale kann ein einfache und schnelle Bedienung der Funktionseinrichtung ermöglicht werden.

Bevorzugt wird die Darstellung durch das zumindest eine Zwischensteuersignal um einen vorgegebenen zweiten Faktor vergrößert oder verkleinert, wobei der zweite Faktor kleiner als der erste Faktor ist. Hierbei ist es auch vorgesehen, dass der Ausschnitt der Darstellung auf der Anzeigeeinrichtung an die Vergrößerung bzw. Verkleinerung der Darstellung angepasst wird.

Dabei können auch mehrere Zwischenpositionen zwischen zwei Raststufen vorgesehen sein, wobei die Darstellung durch jedes der Zwischensteuersignale um einen vorgegebenen Faktor vergrößert oder verkleinert wird. Dabei können die Faktoren für die Vergrößerung bzw. Verkleinerung, die durch die Zwischensteuersignale und Raststeuersignale bewirkt werden, so gewählt werden, dass sich bei der Drehung des Drehstellers einen beinahe kontinuierliche Vergrößerung bzw. Verkleinerung der Darstellung ergibt. Dadurch ergibt sich eine flüssige Maßstabsänderung parallel zur Bewegung des Drehstellers.

In einer weiteren Ausgestaltung werden auf der Anzeigeeinrichtung eine Mehrzahl von Listeneinträgen und ein Auswahlelement zum Auswählen eines der Listeneinträge dargestellt, wobei eine Darstellung des Auswahlelements durch jedes der Raststeuersignale um eine vorgegebene erste Anzahl an Listeneinträgen verschoben wird. Dabei kann es auch vorgesehen sein, dass die Darstellung des Auswahlelements durch ein Raststeuersignal nur um einen Listeneintrag verschoben wird. Damit können die einzelnen Listeneinträge von der Bedienperson zuverlässig ausgewählt werden, wodurch sich eine einfache Bedienung ergibt.

Bevorzugt wird die Darstellung des Auswahlelements durch das zumindest eine Zwischensteuersignal um eine vorgegebene zweite Anzahl an Listeneinträgen verschoben, wobei die zweite Anzahl geringer als die erste Anzahl ist. Damit ergibt sich infolge der Drehung des Drehstellers eine beinahe kontinuierliche Bewegung des Auswahlelements zwischen den einzelnen Listeneinträgen. Wenn eine Mehrzahl von Zwischenpositionen zwischen zwei Raststufen vorgesehen sind, kann in Abhängigkeit von der Drehgeschwindigkeit des Drehstellers die Geschwindigkeit der Verschiebung der Darstellung des Auswahlelements angepasst werden. Mit anderen Worten kann mit dem Drehsteller die Scrollgeschschwindigkeit in einer Liste eingestellt werden. Dies ermöglicht eine einfache und intuitive Bedienung einer Liste.

Schließlich ist es vorteilhaft, wenn die Darstellung des Auswahlelements durch das zumindest eine Zwischensteuersignal in eine Position zwischen zwei der Listeneinträge verschoben wird. Damit erhält die Bedienperson bei Betätigung des Drehstellers eine sofortige Rückmeldung über ihre Bedienhandlung. Die Bedienperson kann beispielsweise direkt erkennen, ob das Auswahlelement bzw. ein Zeiger in der Liste durch die momentane Drehbewegung des Drehstellers in der Liste nach oben oder nach unten verschoben wird. Damit kann insbesondere die Bedienung von vertikalen Listen vereinfacht werden.

Die vorliegende Erfindung wird nun anhand der beigefügten Zeichnungen näher erläutert. Dabei zeigen:
- Fig. 1: eine schematische Darstellung einer Bedienvorrichtung in einer geschnittenen Seitenansicht;
- Fig. 2: eine schematische Darstellung der Bedienung einer Funktionseinrichtung mit einer Bedienvorrichtung; und
- Fig. 3: eine schematische Darstellung der Bedienung einer weiteren Funktionseinrichtung mit der Bedienvorrichtung.

Die nachfolgend näher geschilderten Ausführungsbeispiele stellen bevorzugte Ausführungsformen der vorliegenden Erfindung dar.

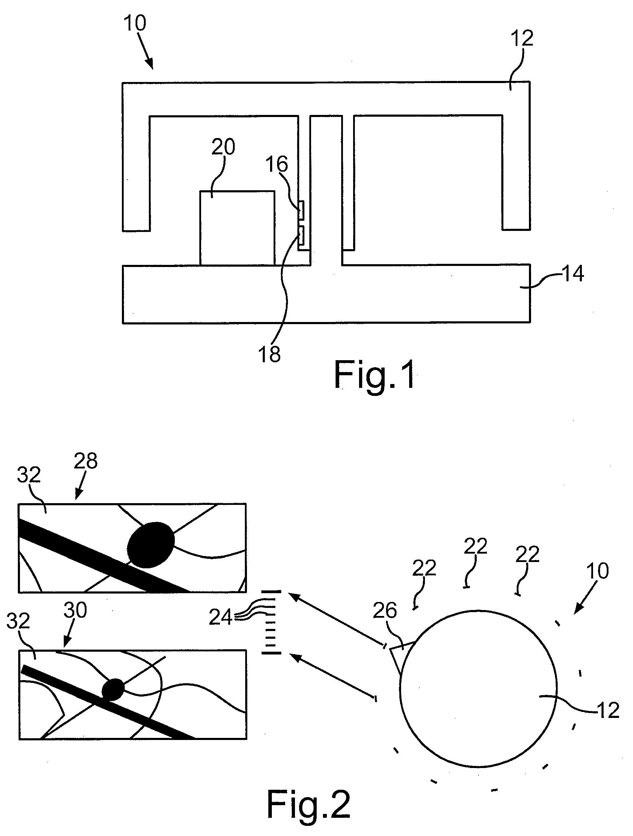

Die Fig. 1 zeigt eine schematische Darstellung einer Bedienvorrichtung 10 in einer geschnittenen Seitenansicht. Die Bedienvorrichtung 10 dient zum Bedienen einer Funktionseinrichtung eines Kraftfahrzeugs. Eine solche Funktionseinrichtung kann eine Klimaanlage, ein Navigationssystem, eine Bedieneinrichtung mit dazugehöriger Anzeige, ein Unterhaltungssystem oder dergleichen sein. Die Bedienvorrichtung 10 umfasst einen Drehsteller 12, der an einem Halteelement 14 drehbar gelagert ist. Des Weiteren sind an dem Drehsteller 12 zwei Kodierelemente 16 und 18 angeordnet. Die Kodierelemente 16, 18 können einen oder mehrere Magnete umfassen. Alternativ dazu können die Kodierelemente 16, 18 elektrische Kontakte umfassen. In einer weiteren Ausführungsform können die Kodierelemente 16, 18 entsprechende Aussparungen umfassen.

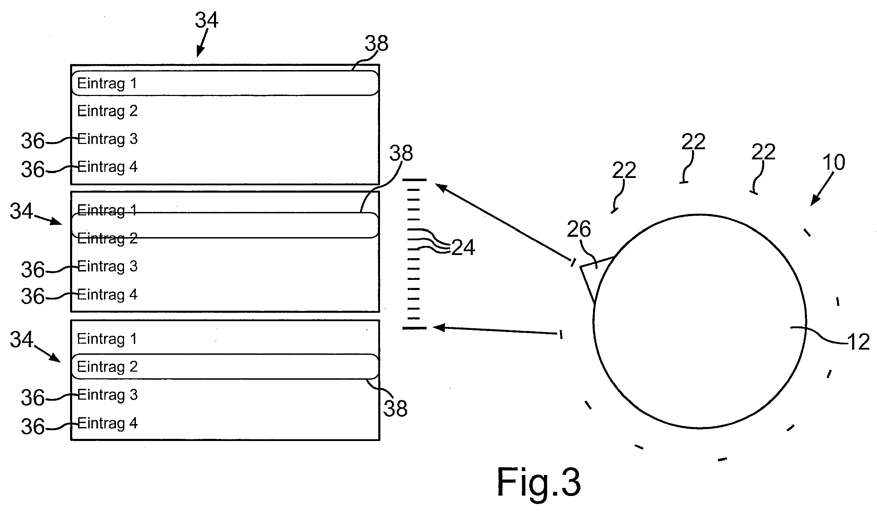

Des Weiteren umfasst die Bedienvorrichtung 10 eine Erfassungseinrichtung 20, die mechanisch fest mit dem Halteelement 14 verbunden ist. Die Erfassungseinrichtung 20 kann ein entsprechendes Sensorelement umfassen, das mit den Kodierelementen 16, 18 so zusammenwirkt, dass von der Erfassungseinrichtung 20 in Abhängigkeit von einer Kodierung der Kodierelemente 16, 18 jeweils ein Ausgangssignal bereitgestellt wird. Wenn die Kodierelemente 16, 18 Magnete umfassen, kann die Erfassungseinrichtung 20 einen magnetischen Sensor, beispielsweise einen Hall-Sensor aufweisen. Weisen die Kodierelemente 16, 18 elektrische Kontakte auf, kann die Erfassungseinrichtung 20 Schleifkontakte umfassen. Sind die Kodierelemente 16, 18 durch Aussparungen gebildet, kann die Erfassungseinrichtung 20 einen optischen Sensor umfassen. Die Bedienvorrichtung 10 weist zusätzlich eine hier nicht dargestellte Rasteinrichtung auf, durch die dem Drehsteller 12 Rastpositionen 22 vorgegeben sind (siehe Fig. 2 und 3).

Durch die Drehung des Drehstellers 12 werden durch die beiden Kodierelemente 16 und 18 in der Erfassungseinrichtung 20 zumindest zwei Ausgangssignale erzeugt. Dabei können die Kodierelemente 16, 18 derart ausgebildet sein, dass sich zwei Ausgangsignale ergeben, die einen im Wesentlichen kontinuierlichen bzw. analogen Verlauf aufweisen. Die Ausgangssignale können auch entlang der Drehrichtung versetzt zueinander sein. Zur Auswertung dieser analogen Ausgangssignale kann jeweils ein Schwellwert vorgebeben werden. In Abhängigkeit von dem Überschreiten oder Unterschreiten des Schwellwerts kann die Drehrichtung und die einzelnen Rastposition 22 ermittelt werden. Des Weiteren kann anhand der Ausgangssignale der Drehwinkel zwischen zumindest zwei Rastpositionen 22 ermittelt werden. Um den Drehwinkel in einem Bereich zwischen zumindest zwei Rastpositionen 22 zu ermitteln, wird die jeweilige Amplitude des Ausgangssignals herangezogen.

Es können auch drei Kodierelemente 16, 18 verwendet werden, wobei die Kodierelemente 16, 18 dabei derart ausgestaltet sein können, dass die Erfassungseinrichtung 20 durch das Erfassen von zwei der drei Kodierelement 16, 18 jeweils ein digitales Ausgangssignal ausgibt. Anhand der digitalen Ausgangssignale kann die Drehrichtung und die einzelnen ermittelt werden. Durch Auswertung des dritten der drei Kodierelemente 16, 18 wird von der Erfassungseinrichtung 20 ein Ausgangssignal ausgegeben, das einen kontinuierlichen bzw. analogen Verlauf aufweist. Anhand des Ausgangssignals kann der Drehwinkel zwischen zwei der Rastpositionen 22 ermittelt werden.

Wenn sich der Drehsteller 12 in einer der Rastpositionen 22 befindet, wird von der Bedienvorrichtung 10 ein Raststeuersignal ausgegeben. Dabei wird für jede der Rastpositionen 22 ein separates Raststeuersignal ausgegeben. Diese Raststeuersignale dienen zur Ansteuerung einer Funktionseinrichtung des Kraftfahrzeugs. Wenn sich der Drehsteller 12 zwischen zwei der Rastpositionen 22 befindet, wird zumindest ein Zwischensteuersignal ausgegeben, das auch zur Ansteuerung der Funktionseinrichtung dient. Das Zwischensteuersignal kann in Abhängigkeit von dem Drehwinkel zwischen zwei Rastpositionen 22 erzeugt werden. Bevorzugt werden zwischen jeweils zwei Rastpositionen 22 eine Mehrzahl von Zwischenpositionen 24 festgelegt, wobei für jede Zwischenposition 24 ein Zwischensteuersignal erzeugt wird, sobald der Drehsteller 12 in die jeweilige Zwischenposition 24 bewegt wird.

Fig. 2 zeigt eine schematische Darstellung, die die Bedienung einer Funktionseinrichtung mit der Bedienvorrichtung 10 verdeutlicht. Die Bedienvorrichtung 10 ist hier in einer Draufsicht dargestellt. Der Drehsteller 12 weist ein Positionselement 26 auf, der die aktuelle Position des Drehstellers kennzeichnet. Vorliegend wird die Bedienvorrichtung 10 zur Steuerung eines Navigationssystems und insbesondere einer Kartendarstellung auf einer Anzeigeeinrichtung des Navigationssystems verwendet. In der momentanen Rastposition 22 des Drehstellers 12 wird eine erste Anzeige 28 der Darstellung 32 auf der Anzeigeeinrichtung dargestellt. Durch die Drehung des Drehstellers 12 kann nun die Darstellung 32 - je nach Drehrichtung - vergrößert oder verkleinert werden.

Wenn der Drehsteller 12 gegen den Uhrzeigersinn in die nächste Rastposition 22 gedreht wird, wird das zu dieser Rastposition 22 gehörige Raststeuersignal ausgegeben, infolge dessen auf der Anzeigeeinrichtung die Anzeige 30 der Darstellung 32 angezeigt wird, bei der die Darstellung 32 im Vergleich zur Anzeige 28 um einen vorbestimmten Faktor verkleinert ist. Zudem ist der Ausschnitt der Darstellung 32 entsprechend angepasst. Dabei ist es auch vorgesehen, dass die Darstellung 32 in Abhängigkeit von den Zwischensteuersignalen in den Zwischenpositionen 24 vergrößert bzw. verkleinert wird, wobei die Darstellung 32 um einen kleineren Faktor vergrößert bzw. verkleinert wird. Dies ermöglicht es, dass eine Bedienperson bzw. der Fahrer den Drehsteller 12 ausgehend von einer Rastposition 22 nicht direkt in die nächste Rastposition 22 dreht, sondern zunächst in eine der Zwischenpositionen 24 zwischen die Rastpositionen 22 dreht. Durch die die Ausgabe des entsprechenden Zwischensteuersignals und der damit verbundenen Änderung der Darstellung 32, kann der Bediener sofort erkennen, ob die Drehrichtung in die er den Drehsteller 12 gerade dreht, eine Vergrößerung oder Verkleinerung der Darstellung 32 bewirkt. Wenn der Bediener den Drehsteller 12 von einer Raststellung 22 gegen den Uhrzeigersinn in einer der Zwischenpositionen 24 dreht, wird er sofort darüber informiert, dass durch diese Drehbewegung eine Verkleinerung der Darstellung 32 erfolgt. Wenn der Bediener dies wünscht, kann er den Drehsteller 12 in die nächste Rastposition 22 drehen.

Wenn er eine Vergrößerung der Darstellung 32 wünscht, kann sie den Drehsteller 12 im Uhrzeigersinn weiter drehen.

Wenn eine ausreichende Anzahl an Zwischenpositionen 24 zwischen den Rastpositionen 22 vorgesehen ist, kann eine Anzeige ermöglicht werden, bei der die Darstellung 32 bei einer Drehung des Drehstellers beinahe kontinuierlich vergrößert bzw. verkleinert wird. Dies ermöglicht es dem Bediener bzw. dem Fahrer die Darstellung 32 durch Bewegung des Drehstellers 12 in die Zwischenpositionen 24 kurzfristig zu ändern. Dies ist beispielsweise der Fall, wenn der Bediener einen Kartenausschnitt momentan vergrößert dargestellt haben möchte. In den Rastpositionen 22 wird dem Bediener eine stabile Vergrößerungsstufe bzw. Zoomstufe der Darstellung 32 angezeigt, die er beispielsweise für das Navigieren verwenden kann.

Fig. 3 verdeutlicht die Bedienung einer Funktionseinrichtung mit der Bedienvorrichtung 10 am Beispiel einer Liste. Auf der Anzeigeeinrichtung wird eine Anzeige 34 mit einer Mehrzahl von Listeneinträgen 36 dargestellt. Zudem wird ein Auswahlelement 38 dargestellt, mit dem er jeweilige Listeneintrag 36 ausgewählt werden kann. In der momentanen Rastposition 22 befindet sich das Auswahlelement 38 über dem Listeneintrag 36 "Eintrag 1 ". Dreht der Bediener bzw. der Fahrer den Drehsteller gegen den Uhrzeigersinn in die nächst Rastposition 22, wird das Auswahlelement zu dem Listeneintrag 36 "Eintrag 2" bewegt. Wenn sich der Drehsteller 12 in einer der Zwischenpositionen 24 zwischen diesen beiden Rastpositionen 22 befindet, wird das Auswahlelement 38 zwischen den beiden Listeneinträgen 36 "Eintrag 1" und "Eintrag 2" dargestellt. Durch die Drehung des Drehstellers 12 in eine der Zwischenpositionen 24 erhält die Bedienperson sofort eine Rückmeldung darüber, ob sich das Auswahlelement 38 durch diese Drehung nach oben oder nach unten bewegt. Zudem ergibt sich infolge der Drehung des Drehstellers 12 eine kontinuierliche Bewegung des Auswahlelements 38 zwischen den einzelnen Listeneinträgen 36.

## Patentansprüche

1. Verfahren zum Bedienen einer Funktionseinrichtung eines Kraftfahrzeugs mit einer Bedienvorrichtung, wobei die Bedienvorrichtung einen Drehsteller (12) umfasst, der an einem Halteelement (14) drehbar gelagert ist und der zumindest ein Kodierelement (16, 18) aufweist, durch
- Erfassen eines absoluten Drehwinkels zwischen dem Drehsteller (12) und dem Halteelement (14) anhand einer Kodierung des zumindest einen Kodierelements (16, 18) und
- Vorgeben einer Mehrzahl von Rastpositionen (22) für den Drehsteller (12) entlang seiner Drehrichtung,
**gekennzeichnet durch**
- Erfassen der jeweiligen Rastposition (22) und des absoluten Drehwinkels zwischen zwei der Rastpositionen (22) anhand der Kodierung des zumindest einen Kodierelements (16, 18) und
- Steuern der Funktionseinrichtung in Abhängigkeit von dem erfassten absoluten Drehwinkel, falls sich der Drehsteller (12) zwischen zwei der Rastpositionen (22) befindet.

2. Verfahren nach Anspruch 1,
**dadurch gekennzeichnet, dass**
für jede die erfassten Rastpositionen (22) ein Raststeuersignal zur Steuerung der Funktionseinrichtung ausgegeben wird.

3. Verfahren nach Anspruch 1 oder 2,
**dadurch gekennzeichnet, dass**
in Abhängigkeit von dem erfassten Drehwinkel zwischen den zwei Rastpositionen (22) zumindest ein Zwischensteuersignal zur Steuerung der Funktionseinrichtung ausgegeben wird.

4. Verfahren nach einem der vorhergehenden Ansprüche,
**dadurch gekennzeichnet, dass**
zwischen den zwei Rastpositionen (22) eine Mehrzahl von Zwischenpositionen (24) festgelegt wird, wobei für jede der Zwischenpositionen (24) ein Zwischensteuersignal zur Steuerung der Funktionseinrichtung ausgegeben wird.

5. Verfahren nach einem der Ansprüche 2 bis 4,
**dadurch gekennzeichnet, dass**
die Funktionseinrichtung eine Anzeigevorrichtung umfasst, wobei eine Darstellung (32) auf der Anzeigeeinrichtung in Abhängigkeit von den Raststeuersignalen und/oder dem zumindest einen Zwischensteuersignal angepasst wird.

6. Verfahren nach Anspruch 5,
**dadurch gekennzeichnet, dass**
die Darstellung (32) auf der Anzeigeeinrichtung durch jedes der Raststeuersignale um einen vorgegebenen ersten Faktor vergrößert oder verkleinert wird.

7. Verfahren nach Anspruch 5 oder 6,
**dadurch gekennzeichnet, dass**
die Darstellung (32) durch das zumindest eine Zwischensteuersignal um einen vorgegebenen zweiten Faktor vergrößert oder verkleinert wird, wobei der zweite Faktor kleiner als der erste Faktor ist.

8. Verfahren nach Anspruch 5,
**dadurch gekennzeichnet, dass**
auf der Anzeigeeinrichtung eine Mehrzahl von Listeneinträgen (36) und ein Auswahlelement (38) zum Auswählen eines der Listeneinträge (36) dargestellt werden, wobei eine Darstellung des Auswahlelements (38) durch jedes der Raststeuersignale um eine vorgegebene erste Anzahl an Listeneinträgen (36) verschoben wird.

9. Verfahren nach Anspruch 8,
**dadurch gekennzeichnet, dass**
die Darstellung des Auswahlelements (38) durch das zumindest eine Zwischensteuersignal um eine vorgegebene zweite Anzahl an Listeneinträgen (36) verschoben wird, wobei die zweite Anzahl geringer als die erste Anzahl ist.

10. Verfahren nach Anspruch 8 oder 9,
**dadurch gekennzeichnet, dass**
die Darstellung des Auswahlelements (38) durch das zumindest eine Zwischensteuersignal in eine Position zwischen zwei der Listeneinträge verschoben (36) wird.

## Claims

1. Method for operating a functional device of a motor vehicle having an operating device, wherein the operating device comprises a rotary adjuster (12) which is rotatably supported on a retention element (14) and which has at least one encoding element (16, 18), by
- detecting an absolute rotation angle between the rotary adjuster (12) and the retention element (14) using an encoding of the at least one encoding element (16, 18), and
- predetermining a plurality of catch positions (22) for the rotary adjuster (12) in the rotation direction thereof,
**characterised by**
- detecting the respective catch position (22) and the absolute rotation angle between two of the catch positions (22) using the encoding of the at least one encoding element (16, 18), and
- controlling the functional device in accordance with the detected absolute rotation angle if the rotary adjuster (12) is located between two of the catch positions (22).

2. Method according to Claim 1,
**characterised in that**
for each of the detected catch positions (22) a catch control signal is emitted to control the functional device.

3. Method according to Claim 1 or 2,
**characterised in that**
depending on the detected rotation angle between the two catch positions (22) at least one intermediate control signal is emitted to control the functional device.

4. Method according to any one of the preceding claims,
**characterised in that**
between the two catch positions (22) a plurality of intermediate positions (24) is determined, wherein for each of the intermediate positions (24) an intermediate control signal is emitted for controlling the functional device.

5. Method according to any one of Claims 2 to 4,
**characterised in that**
the functional device comprises a display device, wherein a display (32) on the display device is adapted in accordance with the catch control signals and/or the at least one intermediate control signal.

6. Method according to Claim 5,
**characterised in that**
the display (32) on the display device is increased or decreased by each of the catch control signals by a predetermined first factor.

7. Method according to Claim 5 or 6,
**characterised in that**
the display (32) is increased or decreased by the at least one intermediate control signal by a predetermined second factor, wherein the second factor is smaller than the first factor.

8. Method according to Claim 5,
**characterised in that**
on the display device a plurality of list entries (36) and a selection element (38) for selecting one of the list entries (36) are displayed, wherein a display of the selection element (38) is displaced by each of the catch control signals by a predetermined first number of list entries (36).

9. Method according to Claim 8,
**characterised in that**
the display of the selection element (38) by the at least one intermediate control signal is displaced by a predetermined second number of list entries (36), wherein the second number is lower than the first number.

10. Method according to Claim 8 or 9,
**characterised in that**
the display of the selection element (38) is displaced by the at least one intermediate control signal into a position between two of the list entries (36).

## Revendications

1. Procédé pour utiliser un système de fonctions d'un véhicule automobile à l'aide d'un dispositif d'utilisation, dans lequel le dispositif d'utilisation comprend un élément de réglage rotatif (12), qui est monté de manière à pouvoir tourner au niveau d'un élément de maintien (14) et qui présente au moins un élément de codage (16, 18), par
- la détection d'un angle de rotation absolu entre l'élément de réglage rotatif (12) et l'élément de maintien (14) à l'aide d'un codage de l'au moins un élément de codage (16, 18), et
- la spécification d'une multitude de positions d'enclenchement (22) pour l'élément de réglage rotatif (12) le long de sa direction de rotation,
**caractérisé par**
- la détection de la position d'enclenchement (22) respective et de l'angle de rotation absolu entre deux des positions d'enclenchement (22) à l'aide du codage de l'au moins un élément de codage (16, 18), et
- la commande du système de fonctions en fonction de l'angle de rotation absolu détecté dans le cas où l'élément de réglage rotatif (12) se trouve entre deux des positions d'enclenchement (22).

2. Procédé selon la revendication 1,
**caractérisé en ce**
**qu'**un signal de commande d'enclenchement pour commander le système de fonctions est émis pour chacune des positions d'enclenchement (22) détectées.

3. Procédé selon la revendication 1 ou 2,
**caractérisé en ce**
**qu'**au moins un signal de commande intermédiaire pour commander le système de fonctions est émis en fonction de l'angle de rotation détecté entre les deux positions d'enclenchement (22).

4. Procédé selon l'une quelconque des revendications précédentes,
**caractérisé en ce**
**qu'**une multitude de positions intermédiaires (24) sont fixées entre les deux positions d'enclenchement (22), dans lequel un signal de commande intermédiaire pour commander le système de fonctions est émis pour chacune des positions intermédiaires (24).

5. Procédé selon l'une quelconque des revendications 2 à 4,
**caractérisé en ce**
**que** le système de fonctions comprend un dispositif d'affichage, dans lequel une représentation (32) sur le système d'affichage est adaptée en fonction des signaux de commande d'enclenchement et/ou de l'au moins un signal de commande intermédiaire.

6. Procédé selon la revendication 5,
**caractérisé en ce**
**que** la représentation (32) sur le système d'affichage est agrandie ou réduite d'un premier facteur spécifié par chacun des signaux de commande d'enclenchement.

7. Procédé selon la revendication 5 ou 6,
**caractérisé en ce**
**que** la représentation (32) est agrandie ou réduite d'un deuxième facteur spécifié par l'au moins un signal de commande intermédiaire, dans lequel le deuxième facteur est inférieur au premier facteur.

8. Procédé selon la revendication 5,
**caractérisé en ce**
**qu'**une multitude d'entrées de liste (36) et un élément de sélection (38) pour sélectionner une des entrées de liste (36) sont représentés sur le système d'affichage, dans lequel une représentation de l'élément de sélection (38) est décalée d'un premier nombre spécifié d'entrées de liste (36) pour chacun des signaux de commande d'enclenchement.

9. Procédé selon la revendication 8,
**caractérisé en ce**
**que** la représentation de l'élément de sélection (38) est décalée d'un deuxième nombre spécifié d'entrées de liste (36) par l'au moins un signal de commande intermédiaire, dans lequel le deuxième nombre est inférieur au premier nombre.

10. Procédé selon la revendication 8 ou 9,
**caractérisé en ce**
**que** la représentation de l'élément de sélection (38) est décalée par l'au moins un signal de commande intermédiaire dans une position entre deux des entrées de liste (36).
